(19) Europäisches Patentamt
European Patent Office
Office européen des brevets

(11) Publication number: **0 484 906 A2**

# EUROPEAN PATENT APPLICATION

(21) Application number: **91118909.0**

(22) Date of filing: **06.11.91**

(51) Int. Cl.⁵: **G11B 5/48**, G11B 5/58

(30) Priority: **09.11.90 US 611271**

(43) Date of publication of application:
**13.05.92 Bulletin 92/20**

(84) Designated Contracting States:
**DE FR GB IT**

(71) Applicant: **BRIER TECHNOLOGY**
**2148 Bering Drive**
**San Jose, CA 95131(US)**

(72) Inventor: **Bizjak, John F.**
**5896 Porto Alegre**
**San Jose, CA 95129(US)**
Inventor: **Cardona, Joseph**
**2395 West Hedding Street**
**San Jose, CA 95128(US)**

(74) Representative: **Zenz, Joachim Klaus,**
**Dipl.-Ing. et al**
**Patentanwälte Zenz, Helber & Hosbach Am**
**Ruhrstein 1**
**W-4300 Essen 1(DE)**

(54) **Head mounting device.**

(57) A head mounting assembly utilizing a specially designed printed circuit board ("PCB") for supporting a read/write head (235) for a floppy disk drive computer memory unit is presented. The PCB flexure replaces the metal flexure of the prior art. The PCB flexure is configured so as to provide a similar degree of flexibility as the metal flexure of the prior art. The electrical leads of the read/write head (235) are connected to first ends (295) of conductive strips (280) formed on the surface of the PCB flexure. The other ends (280) of the conductive strips are connected to the disk drive's electronics package by means of a single flexible circuit. Additional electronic components such as preamplifier may be mounted on the PCT flexure itself or on the flexible circuit limiting the amount of noise and other interference that may degenerate the signals passing from the read/write head to the disk drive's electronics.

FIG. 9

BACKGROUND OF THE PRESENT INVENTION

1. FIELD OF THE INVENTION

The present invention relates to the field of disk drive memory units for computers, and more particularly to a read/write head mounting assembly for a floppy or rigid disk drive.

2. BACKGROUND OF THE INVENTION

Mass storage for computer or other information systems is typically provided by magnetic media storage systems, such as rigid or flexible disk storage systems. A rotating disk having a magnetic media layer on the surface is accessed by a "read/write" head, which is used to store and retrieve information from the disk surface. To store information on a magnetic media disk, flux reversals are induced in the magnetic particles comprising the surface. When a magnetic read/write head is passed over the flux reversals, a signal is induced in the head which can be decoded to provide information.

Typically, data is stored on a magnetic disk on a series of spiral or concentric "tracks" on the surface of the disk. The read/write head moves back and forth radially on the disk so that it can be selectively positioned over one of the tracks. Once in position over a track, the head remains in place as the track rotates beneath it, allowing the head to read or write data on the track.

In a flexible media disk drive system, also known as a "floppy disk drive" or "floppy drive," flexible magnetic media enclosed in a protective casing is inserted into a disk drive opening and accessed by a pair of read/write heads. One read/write head is on one side of the disk and an opposing read/write head mounted on the opposite side of the disk. An opening in the protective casing allows the heads to contact the disk surface directly. One of the read/write heads is mounted on a flexure assembly which in turn is mounted on an arm assembly. The other read/write head is either mounted on a similar flexure assembly or a stiffer flexure assembly which in turn is mounted on an arm assembly. Some prior art heads are mounted directly on the arm assembly without a flexure assembly. The mounting arms are coupled to or integral with a head carriage which, under the direction of a carriage motor, can be moved back and forth in a radial direction to position the heads over specific data tracks. To improve data integrity and to maintain accurate head position and alignment, the heads are spring-loaded onto the disk. This is accomplished by having one of the head mounting arms hinged and biased with an urging spring to cause the disk to be "squeezed" between the pair of read/write heads.

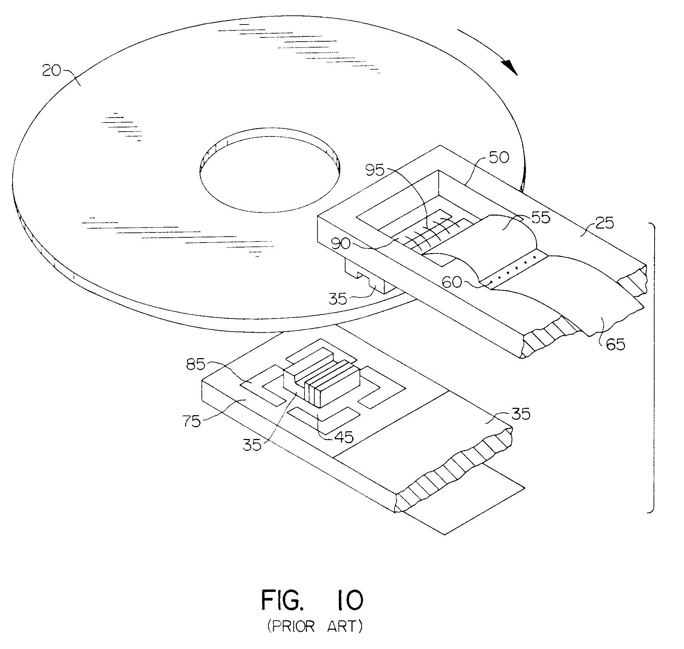

A typical prior art head mounting assembly for floppy disk drives is shown in Figure 10. Two cantilevered support arms 25 and 30 respectively are positioned on opposite sides of a removable floppy disk 20. The back ends of support arms 25 and 30 are attached to a carriage (not shown) that allows the free ends of support arms 25 and 30 to move in a radial direction across the top and bottom surfaces, respectively, of floppy disk 20 to transfer information to and from memory tracks located on the top and bottom surfaces of the disk. Usually lower support arm 30 is affixed to the carriage, while upper support arm 25 is hinged or otherwise flexibly attached to allow upper arm 25 to be lifted away from lower arm 30 to allow insertion and removal of floppy disk 20. A spring, not shown, urges the arm 25 toward the disk during drive operation.

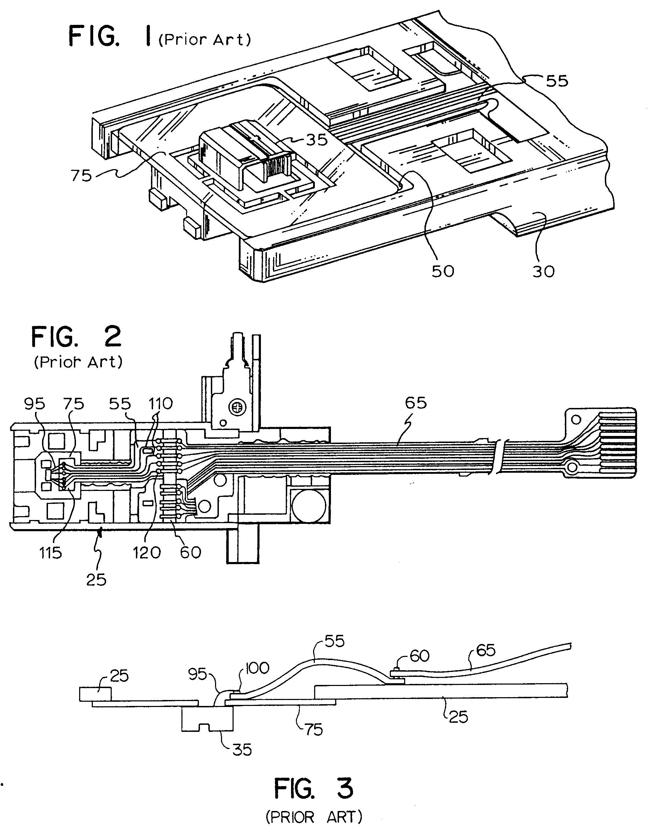

Each of the two support arms 25 and 30 has an electromagnetic read/write head 35 mounted adjacent to its free end. Each read/write head 35, rather than being mounted directly to one of the support arms 25 and 30, is instead mounted to a mounting plate 75 (flexure assembly). Referring now to Figure 1, plate 75 is typically made from a copper or stainless steel alloy and has a thickness of about 50 to 300 microns. Mounting plate 75 may have vairous shapes (two examples of which are shown in Figures 1 and 2) and can be attached to the support arm assemblies 25 and 30 in different ways. In a typical arrangement, one relatively flexible mounting plate and one relatively rigid mounting plate are used. The flexible plate is flexible enough to easily allow the read/write head to tilt to maintain continous contact with the surface of the floppy disk 20 while being resilient enough to prevent horizontal motion. To prevent vertical motion of the read/write head as well, the flexible plate is fixedly attached to its support arm. The other mounting plate is typically significantly stiffer than the flexible plate, so as to allow little or no tilt, but is attached to its support arm in such a way as to allow some vertical movement. Depending on the degree of flexibility desired, flexure 75 may be provided with rectangular or L-shaped cutouts to define a central region of increased flexibility.

Flexure 75 in turn is mounted over a rectangular aperture adjacent the free end of the applicable support arm. This aperture is indicated by reference numeral 50.

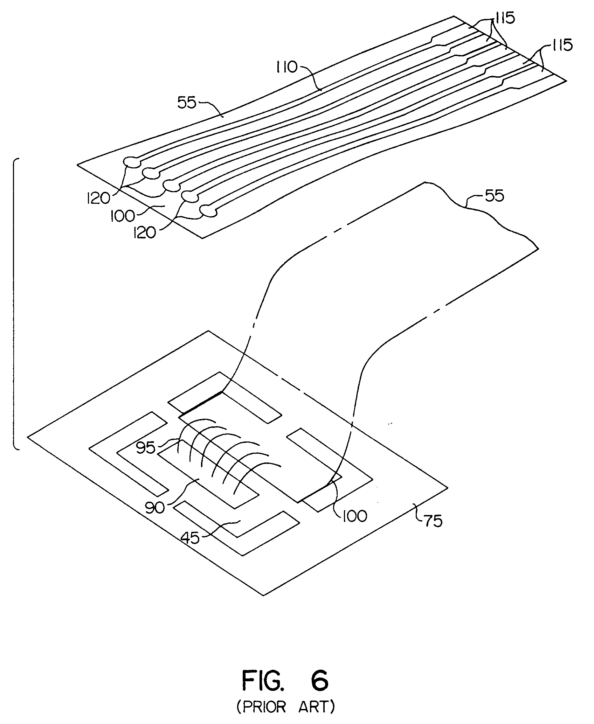

Referring to Figures 2 and 3, an intermediate flexible circuit 55 is attached between flexure 75 and an anchor point 60 on support arm 25. Alternatively, a wire or cable may be used. Intermediate flexible circuit 55 typically consists of a flexible polymide strip approximately 50 microns in thickness. As shown in Figure 6, a number of conductive copper strips 110 are formed on the surface of intermediate flexible circuit 55, and contact surfaces 115 and 120 are formed at their respective back and front ends. As shown in Figures 3 and 6, the front edge of intermediate flexible circuit 55 is bonded to a central portion 45 of flexure 75 adjacent to read/write head 35. Electrical leads 95 of read/write head 35 are soldered to the contact surfaces 115. As shown in Figures 10 and 3, the other end of flexible circuit 55 is attached to an anchor point 60 on the back of upper support arm 25. A second flexible circuit 65 is also connected to anchor point 60. Alternately a wire or cable may be used. This second flexible circuit 65 connects intermediate flexible circuit 55 to the disk drive's electronics package mounted adjacent to the carriage.

Two separate flexible circuits 55 and 65 (or equivalent wires or cables) are required in prior art disk drives. The intermediate flexible circuit 55 is required in the prior art to reduce the strain on the delicate leads 95 of read/write head 35 and to allow the free movement of flexure 75. If a single long flexible circuit were connected directly between read/write head 35 and the disk drive's remotely located electronics package, movement of the long flexible circuit as the carriage assembly moves back and forth in a radial direction with respect to floppy disk 20 would exert forces on flexure 75. These forces would inhibit the free movement necessary for read/write head 35 to maintain the degree of surface contact with the floppy disk 20 required for proper operation. To prevent such interference, the back end of intermediate flexible circuit 55 must be anchored to the anchor point 60 to isolate read/write head 35 from the stresses induced by movement of the second flexible circuit 65. However, even with its end anchored, intermediate flexible circuit 55 creates a certain amount of resistance to the free movement of read/write head 35.

Certain prior art improvements to read/write head mounting schemes have been proposed.

U.S. Patent No. 4,809,103 issued to Lazzari discloses a slider with an integrated magnetic head, preamplifier circuitry and readout lines. The readout lines are connected by wires to the rest of the disk drive electronics. The head assembly described in "Lazzari" is built on the 100 face of a single crystal silicon wafer. Due to the rigid nature on the silicon, it is necessary for this read/write assembly to be connected to a spring assembly to provide the vertical motion necessary to the operation of a read/write head assembly.

U.S Patent No. 4,432,027 issued to "Higuchi" describes a disk drive head assembly in which the head mounted on a elastic support plate and electrical connections ar made through electrical conductors formed on a flexible insulator. The flexible insulator is supported by the plate.

U.S. Patent No. 4,819,094 issued to "Oberg" and U.S. Patent No. 4,823,217 issued to "Kato et al" describe traditional mounting schemes using metal spring plates and flex circuits. The invention described in "Oberg" uses a flexible circuit to make the electrical connection between the read/write head and the associated disk drive electronics. The flexible circuit serves the dual purpose of making the electrical connections and also damping the characteristic vibrations of the read/write head support arm. A similar flexibel circuit arrangement is disclosed in "Kato et al". One embodiment of "Kato et al" makes the electrical connections between a read/write head and associated disk drive electronics through the printed wiring on a flexible printed circuit board.

"Higuchi", "Oberg", and "Kato et al" disclose the use of flexible circuits for connecting a read/write head to the disk drive electronics. None of these patents, however, uses a PC board as the support arm of the read/write head assembly. Mounting the head on the flexible circuit board, use of the PC board to support the head and to carry the readout lines appears to distinguish the present invention from those discussed above.

In "Lazzari", the read/write head is mounted directly on the support means. Similarily, the support means carries the readout lines. In addition, "Lazzari" descibes the desirability of a preamplifier located close to the read/write head. "Lazzari" accomplishes that function with an integrated circuit built on the piece of silicon that serves as the support arm. The present invention is different in that it does not rely on the use of silicon to achieve its function. By avoiding the use of single crystal silicon, the present invention can be accomplished at a lower cost with greater durability. In addition, the integral head of "Lazzari" could not be accomplished without the use of a silicon substrate.

It is an object of the present invention to simplify the method by which the drive control electronics connect with a floppy disk read/write head.

It is a further object of the invention to provide a method to condition or process the electrical signals from the read/write head as near to the head as possible.

It is further object of the invention to provide a multifunctional head suspension mounting.

## SUMMARY OF THE PRESENT INVENTION

In the preferred embodiment of the present invention, a printed circuit board ("PCB"), rather than the metal plate of the prior art, forms the flexure that supports the read/write head. This PCB flexure in turn is mounted to the support arm of the disk drive actuator carriage. The PCB flexure is configured so as to provide a similar degree of flexibility as the metal flexure of the prior art. The electrical leads of the read/write head are connected to first ends of conductive strips formed on the surface of the PCB flexure. The other ends of the conductive strips are connected to the disk drive's electronics package by means of a single flexible circuit. Only one flexible circuit is required. The advantages of using a PCB flexure are realized by combining the mechanics of the head flexure and the electrical head connections into a single integrated component. In an additional embodiment, electronic components such as a preamplifier may be mounted to the PCB flexure itself or on the flexible circuit connected to the PCB flexure, limiting the amount of noise and other interference that may degenerate the signals passing from the read/write head to the disk drive's electronics package.

## BRIEF DESCRIPTION OF THE DRAWINGS

Figure 1 is a perspective view showing a floppy disk drive head mounting assembly of the prior art.

Figure 2 is a bottom plan view of the lower support arm of the head mounting assembly of the prior art shown in Figure 1.

Figure 3 is a side sectional view of the lower support arm of the head mounting assembly shown in Figure 2.

Figure 4 is a perspective view of the preferred embodiment of the floppy disk drive head mounting assembly of the present invention.

Figure 5 is a bottom view of the head mounting assembly of Figure 4.

Figure 6 is a perspective view showing the interconnection between a flexible circuit and a metal flexure of the prior art.

Figure 7 is a perspective view of the preferred embodiment of the PCB flexure of the present invention.

Figure 8 is a top view of the PCB flexure shown in Figure 7.

Figure 9 is a bottom view of the PCB flexure shown in Figure 7.

Figure 10 is a perspective view of a prior art head mounting assembly for a floppy disk drive

## DETAILED DESCRIPTION OF THE PRESENT INVENTION

A head mounting scheme for a floppy disk drive is described. In the following description, numerous specific details, such as disk size, capacity, etc., are set forth in detail in order to provide a more thorough understanding of the present invention. It will be apparent, however, to one skilled in the art, that the present invention may be practiced without these specific details. In other instances, well known features have not been described in detail so as not to unnecessarily obscure the present invention.

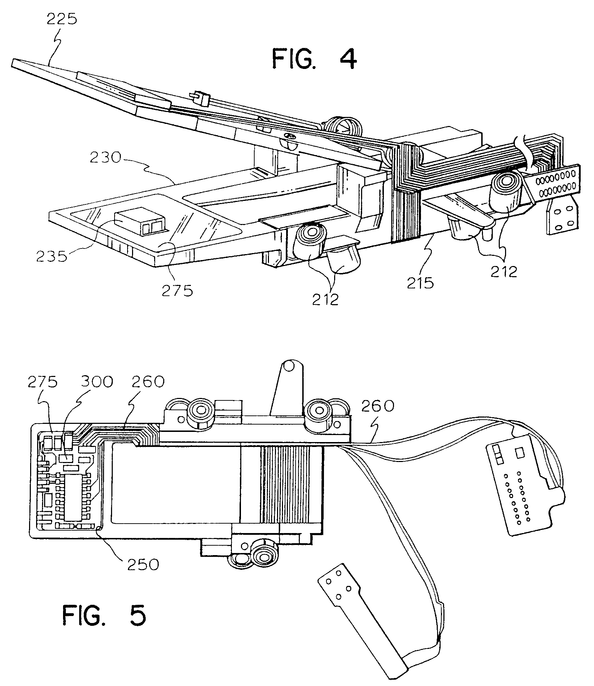

The preferred embodiment of the floppy disk drive head mounting assembly of the present invention is shown in Figures 4-5. The basic structure of the head mounting assembly of the present invention is similar to that of the prior art. Upper and lower support arms 225 and 230, respectively, are mounted to a carriage 215. Electromagnetic read/write heads 235 are mounted to flexures 275 adjacent the free ends of support arms 225 and 230. Carriage 215 rides on rails mounted to the chassis of the floppy disk drive unit by means of bearings 212. A removable floppy disk can be inserted between upper and lower support arms 225 and 230. Flexures 275 are resilient enough to accurately maintain read/write heads 235 in a fixed horizontal position with respect to the floppy disk yet flexible enough to allow a limited range of vertical movement to compensate for irregularities in the position of the floppy disk. This vertical compliance insures that read/write heads 235 maintain continuous contact with the surface of the floppy disk as it rotates about its axle. The position of the carriage, and, consequently, read/write heads 235, is controlled by an electronic servo control system which forms part of the disk drive's electronics contained on a printed circuit board mounted to the chassis of the disk drive unit.

In the prior art, the flexure supporting the read/write head is made of metal, and an intermediate flexible circuit is required to provide electrical contact between the read/write head and the main flexible circuit leading to the disk drive's electronic package. In the present invention the flexure 275 is made from printed circuit board material, and the flexure 275 itself is used to for electrical connection between the read/write head and the disk drive's electronics. The need for an intermediate flexible circuit of the prior art is thereby eliminated.

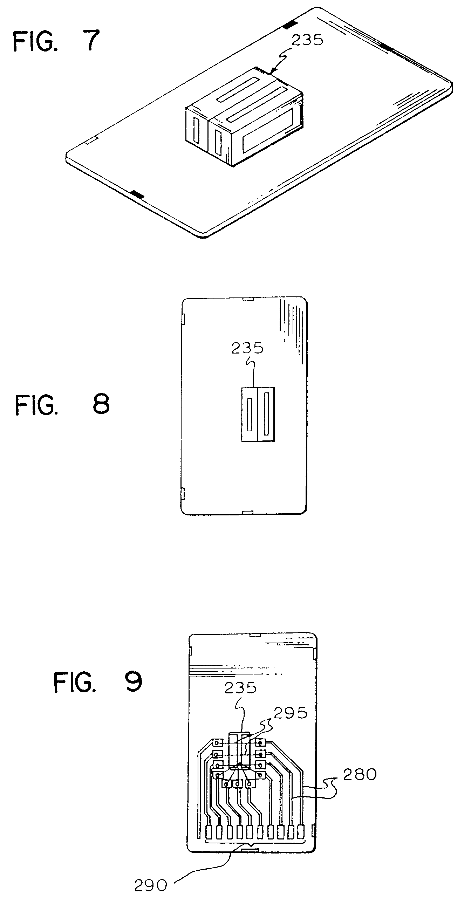

The flexure of the present invention is shown in detail in Figures 7, 8, and 9. Instead of being formed of metal like a prior art flexure, flexure 275 is actually a specially designed printed circuit board. As shown in Figure 7, flexure 275 consists of a thin, rectangular wafer of a resilient, non-conductive substrate such as resin impregnated fiberglass, as is commonly used in the fabrication of printed circuit boards. As used in the flexure of the present invention, this substrate preferably has a density of approximately 0.10 Lb M/In$^3$ (pounds mass/cubic inch) and a modulus of elasticity of approximately $1\times10^6$ Lb F/In$^2$ (pounds force/square inch). This compares to typical values for stainless steel and copper alloy used for flexures of the prior art as follows.

| Material | Density | Modulus of Elasticity |
|---|---|---|
| Stainless Steel | 0.28 Lb M/In$^3$ | $28\times10^6$ Lb F/In$^2$ |
| Copper Alloy | 0.30 Lb M/In$^3$ | $19\times10^6$ Lb F/In$^2$ |

A series of conductive strips 280, preferably of copper alloy, are formed on one of the surfaces of flexure 275. In the embodiment shown in Figures 7 8 and 9, the conductive strips 280 are located on the flexure's bottom surface. The conductive strips may alternatively be located on the top surface or may even be sandwiched in between two substrate layers in a configuration analogous to a multi-layered printed circuit board. The conductive strips 280 run from a first set of contact surfaces 290 located adjacent the perimeter of flexure 275 to a second set of contract surfaces 295 located adjacent to the read/write head 235. Read/write head 235 is preferably mounted to flexure 275 by an epoxy adhesive, and the electrical leads 295 of the read/write head 235 are soldered to contact surfaces 285.

Since both the contact surfaces 290 and read/write head 235 are fixedly attached adjacent to each other to flexure 275, there is no movement of one with respect to the other, and no stress is places on the connection between contact surfaces 290 and the delicate read write head wire leads (In the prior art, the movement of the intermediate flexible circuit attached to the read/write head can cause damage to the read/write head wire leads).

As shown in Figures 4 and 5, the entire flexure-read\write head assembly is in turn mounted over a rectangular aperture 250 in lower support arm 230. In the preferred embodiment flexure 275 is bonded to the sides of rectangular aperture 250 by means of an epoxy adhesive. A single flexible circuit segment 260 is used to connect the contact surfaces 290 (shown in Figure 9) directly to the disk drive's electronics. Because contact surfaces 290 are located adjacent to the edges of flexure 275, which are fixedly bonded to support arm 235, contact surfaces 290 exhibit very little movement as the central portion of flexure 275 flexes to compensate for any surface irregularities of the floppy disk. Contact surfaces 290 therefore form sturdy contact points to which flexible circuit 260 can be attached. Because the conductive strips 280 of flexure 275 form a flexible yet sturdy electrical connection between flexible circuit 260 and read/write head 235, the separate intermediate flexible circuit of the prior art is no longer required. In addition, because of the support provided to flexible circuit 260 by flexure 275, additional electrical components can be supported on flexible circuit 260 without adversely affecting the freedom of movement of read/write head 235.

As shown in Figure 5, in the preferred embodiment of the present invention, certain electrical components such as a preamplifier 300 and associated electrical components are mounted directly on flexible circuit 260 adjacent to flexure 275. Alternatively, these components can be mounted directly to the PCB flexure 275. The length of the path that signals have to travel from read/write head 275 to preamplifier 300 is thereby greatly reduced as compared to the prior art, and the amount of outside interference (noise) to which signals from the read/write head are exposed is minimized. As a result the signal to noise ratio is increased, the strength of the magnetic field required to receive an error free signal from read/write head 235 is reduced, and a smaller portion (magnetic domain) of the magnetic surface of floppy disk 220 is needed to store a given amount of data. As a result, a greater number of memory regions (magnetic domains) can be packed onto a floppy disk, and increased storage capacities can be attained.

Accordingly, the present invention simplifies the fabrication of a floppy disk drive head assembly by reducing the number of flexible circuits required to connect a read/write head to external electronic circuitry and by simplifying and strengthening the electrical connections to the read/write head. The PCB head mounting flexure of the present invention forms a sturdy platform for connecting a flexible circuit to the read/write head. It also allows a preamplifier or other electronic circuitry to be mounted to the PCB flexure itself or to the flexible circuit. The strength of a signal required to accurately transfer information to and from a floppy disk is thereby reduced, allowing for greater floppy disk storage capacities.

Although the present invention has been described with respect to the present preferred embodiment, other embodiments incorporating the inventive features of the present invention are possible. For instance, instead of being supported on all four sides, the PCB flexure may be supported only at one end, such that it becomes a cantilevered flexure. This configuration of the flexure of the present invention would be suitable for use, for example, in a hard disk drive unit. The flexibility of the flexure can easily be changed by varying the thickness or the geometry of the flexure or by fabricating the flexure from different substrate materials or by introducing voids (holes or grooves) in the PCB flexure. The PCB flexure of the present invention may contain additional electrical components such as a preamplifier in addition to the conductive strips and the read/write head described above. The flexure of the present invention can be used with an optical read/write head as well as with the electromagnetic read/write head used in the preferred embodiment. In fact, the PCB flexure of the present invention can be used in any instance where it is desired to flexibly support a component requiring external electrical connections.

## Claims

1.  A flexure (275) for supporting a transducer (235) adjacent to a memory medium (220) characterized by
    a low conductivity resilient substrate; and
    a high conductivity region (280, 290, 295) formed on said subtrate.

2.  The flexure of claim 1 characterized in that the transducer comprises a read/write head (235).

3.  The flexure of claim 2 characterized by a transducer mounting region to which the read/write head (235) is mounted and an external support mounting region by which the flexure (275) is mounted to an external support (225, 230) and wherein said high conductivity region forms an electrical connection (280) between said read/write head mounting region (295) and an external electrical contact region (290).

4.  An assembly for supporting a read/write head (235) adjacent to a memory medium (220) characterized by:
    a support arm (225, 230) movable adjacent to said memory medium (220);
    a flexure (275) affixed to said support arm (225, 230) for supporting said read/write head (235) adjacent to said memory medium (220), said flexure comprising:
    a low conductivity resilient substrate; and
    a high conductivity region (280, 290, 295) formed on said substrate.

5.  The read/write head supporting assembly of claim 4 characterized in that the flexure (275) comprises a read/write head mounting region to which the read/write head is mounted and an external support mounting region by which the flexure is mounted to the support arm, and wherein said high conductivity region forms an electrical connection between said read/write head mounting region and an external electrical contact region of said flexure.

6.  The device of claim 3 or 5 characterized by a flexible circuit means comprising conductive element means, said conductive element means being electrically connected to said external electrical contact region (290) of said high conductivity region formed on said substrate.

7.  The device according to any of claims 1 to 6 characterized in that said substrate comprises a wafer of resin impregnated fiberglass.

8.  The device according to any of claims 1 to 6 characterized in that said substrate comprises a ceramic wafer.

9.  The device according to any of claims 1 to 6 characterized in that said substrate comprises a wafer of PCB material.

10. The device according to claims 1 to 9 characterized by electrical component means (260) connected to said high conductivity region.

EP 0 484 906 A2

**11.** The device of claim 10 characterized in that said electrical component means (260) comprises preamplifier (300) or signal conditioning means.

**12.** The device according to any of claims 2 to 11 characterized in that said read/write head (235) comprises electromagnetic read/write head means.

**13.** The device according to any of claims 2 to 11 characterized in that said read/write head comprises optical read/write head means.

**14.** The device according to any of claims 4 to 13 characterized by carriage means for supporting said support arm.

**15.** The device of claim 14 characterized in that said support arm is movably attached to said carriage means.

**16.** A flexure (275) for resiliently supporting a component (235) requiring external electrical connections (280) characterized by
a low conductivity resilient substrate; and
a high conductivity region formed on said substrate for providing electrical connections.

7

FIG. 1 (Prior Art)

55

35

75

50

30

FIG. 2
(Prior Art)

95    75    55    110

65

115    25    120    60

FIG. 3
(PRIOR ART)

55

60

65

25    95    100

35    75    25

225

FIG. 4

230

235

275

212

215

212

275   300   260

260

250

FIG. 5

FIG. 6
(PRIOR ART)

FIG. 7

235

FIG. 8

235

FIG. 9

235

295

280

290

FIG. 10
(PRIOR ART)